# EUROPÄISCHE PATENTSCHRIFT

(11) **EP 2 219 425 B1**
(45) Veröffentlichungstag und Bekanntmachung des Hinweises auf die Patenterteilung: **12.02.2020**
(21) Anmeldenummer: 09011837.3
(22) Anmeldetag: 17.09.2009
(51) Int. Cl.: H05K 1/14, H05K 1/18

(54) **Schaltungsmodul, insbesondere Steuerungsmodul für ein Fahrdynamikregelsystem**
Circuit module, in particular control module for a driving dynamics regulating system
Module de circuit, notamment module de commande pour un système de réglage de la dynamique de conduite

(30) Priorität: 03.02.2009 DE 102009007270
(43) Veröffentlichungstag der Anmeldung: 18.08.2010
(73) Patentinhaber: WABCO GmbH, 30432 Hannover (DE)
(72) Erfinder: Bolzmann, Oliver, 30161 Hannover (DE); Fabian, Alexander, 31224 Peine (DE); Grimm, Matthias, 30457 Hannover (DE); Gröger, Jens, 30449 Hannover (DE); Gründker, Oliver, 30900 Wedemark (DE); Küster, Klaus, 30455 Hannover (DE); Lehrmann, Joachim, 31275 Lehrte (DE); Rathjen, Frauke, 30453 Hannover (DE); Spitzer, Volker, 30916 Isernhagen (DE)
(74) Vertreter: Lauerwald, Jörg

(56) Entgegenhaltungen:
- EP-A1- 1 575 344
- DE-A1- 10 134 620
- DE-A1-102007 052 366
- FR-A1- 2 918 243
- JP-A- 9 326 575
- US-A1- 2002 110 178

## Beschreibung

Die Erfindung betrifft ein Schaltungsmodul, das insbesondere eine Steuereinrichtung für ein Fahrdynamikregelsystem eines Fahrzeugs sein kann.

Bei verschiedenen Schaltungsmodulen ist die Anbringung eines Bauelementes, insbesondere eines Sensors, in einer vertikalen Lage relativ zu einer Leiterplatte erforderlich. Insbesondere bei Fahrdynamikregelsystemen ist auch eine Sensierung von Trägheitskräften und/oder -momenten mittels eines vertikal zur Leiterplatte angebrachten Sensors erforderlich. Der Sensor ist hierbei z. B. als mikromechanischer, integrierter Schaltkreis (IC) ausgebildet und wird im Allgemeinen zunächst auf einem Zusatz-Träger befestigt, der nachfolgend auf der Leiterplatte montiert wird.

Der Zusatz-Träger wird separat von der Haupt-Leiterplatte bzw. Haupt-Platine hergestellt und zu bestückt, dann über ein Kabel mit der Haupt-Leiterplatte verbunden und in die Haupt- Leiterplatte gesteckt oder durch Löten verbunden. Ergänzend kann ein Halter aufgesteckt werden, um den bereits montierten Zusatz- Träger mechanisch zu sichern.

Eine derartige Herstellung ist jedoch relativ kostenintensiv und aufwendig, da zwei Schaltungsträger separat herzustellen, zu bestücken und zu prüfen sind. Aufgrund der hohen Vibrationsbeanspruchung im Fahrzeug wird oftmals ergänzend eine zusätzliche Klebung des Zusatz- Trägers oder seines Halters auf der Haupt- Leiterplatte erforderlich sein, um eine spielfreie Befestigung zu erreichen. Auch ist die Ausrichtung des Zusatz-Trägers gegenüber der Haupt-Leiterplatte im Allgemeinen nicht sehr präzise. Die hierbei resultierenden Winkelfehler führen jedoch zu Messfehlern. Weiterhin ist oftmals eine verdeckte Montage des Halters erforderlich, was wiederum problematisch ist.

DE 101 34 620A1 offenbart ein mehraxiales Inertialsensorsystem, insbesondere Drehraten- und Beschleunigungssensorsystem für die Fahrdynamikregelung in Kraftfahrzeugen, wobei mehrere, jeweils den Sensorachsen zugeordnete Sensorchips auf Wafer-Ebene auf mehreren jeweils entsprechend einer Sensorachse ausgerichteten oder ausrichtbaren starren Schaltungssubstraten fixiert und elektrisch damit kontaktiert sind und die Schaltungssubstrate untereinander durch flexible oder starre Verbindungsstrukturen mechanisch und elektrisch verbunden sind.

EP 1 575 344 A1 offenbart ein Steuergerät mit einem parallelen Steckerabgang, das sich dadurch auszeichnet, dass der Stecker so kontaktiert ist, dass ein möglichst großer Bereich der Grundfläche einer Leiterplatte mit elektronischen Bauelementen bestückt werden kann und auch ein möglichst großer Bereich dieser mehrlagigen Leiterplatte mit Leiterbahnen zur Verbindung dieser elektronischen Bauelemente versehen werden kann. Dies wird dadurch gelöst, dass ein erster Teil der Leiterplatte mit einem den Steckverbinder tragenden zweiten Teil über einen Biegebereich verbunden ist. Hierbei weisen der erste und zweite Teil zumindest vier Lagen und der Biegebereich zumindest zwei Lagen auf.

JPH09326575 A offenbart eine LED-Tragestruktur, welche aus einer aus einer Haupt-Leiterplatte ausgeschnittenen Zusatz-Leiterplatte besteht, welche über einen Halter in einer Winkelstellung zur Haupt-Leiterplatte gehalten wird. Die elektrische Verbindung der Leiterplatten erfolgt über Drähte.

FR2918243 A1 offenbart eine starrflexible Leiterplatte mit zwei starren Leiterplattenabschnitten, wobei der eine Leiterbahnabschnitt ein Sendemodul und der andere Leiterbahnabschnitt ein Steuermodul bildet. Das Sendemodul und das Steuermodul werden durch eine Abdeckung zueinander in unterschiedlichen Ebenen gehalten.

Der Erfindung liegt die Aufgabe zugrunde, eine einfache und sichere Montage eines Zusatz-Trägers auf einer Haupt-Leiterplatte in einer gewünschten Winkelstellung, insbesondere in vertikalen bzw. orthogonaler Stellung, zu ermöglichen.

Diese Aufgabe wird durch ein Schaltungsmodul nach Anspruch 1 gelöst. Die Unteransprüche beschreiben bevorzugte Weiterbildungen. Ergänzend ist das Verfahren zur Montage bzw. Herstellung des Schaltungsmoduls vorgesehen.

Der Erfindung liegt der Gedanke zugrunde, auch den Zusatzträger als Leiterplatte bzw. als Leitenplattenbereich auszubilden, der mit der Haupt-Leiterplatte über mindestens einen flexiblen Verbindungsbereich verbunden ist. Hierbei können z.

B. zwei parallel verlaufende Verbindungsbereiche zwischen der Zusatz-Leiterplatte und der Haupt-Leiterplatte ausgebildet sein. In den Verbindungsbereichen verlaufen ein oder mehrere Leiterbahnen, die sich bis in die Haupt-Leiterplatte und Zusatz-Leiterplatte erstrecken. Vorteilhafterweise sind keine weiteren elektrischen Verbindung zwischen der Haupt-Leiterplatte und der Zusatz-Leiterplatte vorgesehen.

Die Positionierung und Fixierung der Zusatz-Leiterplatte wird durch einen Halter bewirkt, der durch einen Montagevorgang an der Haupt-Leiterplatte aufgebracht wird und hierbei die Zusatz-Leiterplatte in ihre relevante Position bringt und dort fixiert.

Erfindungsgemäß entfallen somit aufwendige Kontaktierungen durch zusätzliche Leitungen oder Kabel zwischen den Leiterplatten. Es können direkt Leiterbahnen verwendet werden, die in den flexiblen, elastischen Verbindungsbereichen verlaufen, so dass Defekte durch Vibrationen und Schwingungen vermieden werden können. Indem die Verbindungsbereiche nicht nur flexibel, sondern auch elastisch sind, wird bereits eine Vorspannung zur Erleichterung des Montagevorgangs erreicht.

Sowohl die Haupt-Leiterplatte als auch die Zusatz-Leiterplatte werden aus einer gemeinsamen Grund-Leiterplatte ausgebildet, indem Freiräume zwischen den beiden Leiterplattenbereichen ausgebildet werden und der mindesten eine Verbindungsbereich durch Tiefenfräsen bis auf eine oder mehrere flexible untere oder obere Schichten ausgebildet wird. Insbesondere kann z. B. eine untere flexible Lage verbleiben, in der die relevanten Leiterbahnen verlaufen. Somit ist eine direkte und schnelle Herstellung aus einer Grund-Leiterplatte möglich, indem zunächst die Freiräume und die Verbindungsbereiche gefräst werden, nachfolgend die Grund-Leiterplatte bestückt wird (oder auch umgekehrt), und nachfolgend durch Montieren des Halters direkt das fertige Schaltungsmodul ausgebildet wird.

Nachfolgend kann ergänzend Lack bzw. ein Klebemittel aufgebracht werden zur Passivierung und Verringerung von Schwingungsbeanspruchungen. Hierzu kann in der vorzugsweise vertikal verlaufenden Anlagefläche eine Profilierung, z. B. eine Riffelung oder Rillen, zum Durchlassen des Lacks oder Klebemittels in der Einbauposition ausgebildet sein. Auch in den Führungsnuten kann eine derartige Riffelung oder Rillen ausgebildet sein.

Die Anbringung des Halters wird durch eine einfache translatorische Schiebebewegung erreicht, indem der Halter mittels einer Führungseinrichtung, nämlich seitlichen Führungsnuten, in die angrenzenden Kanten der Haupt-Leiterplatte eingefädelt wird und während des translatorischen Verschiebevorgangs direkt die Zusatz-Leiterplatte aufnimmt, die an einer Anlagefläche des Halters entlang in ihre vertikale Position gleitet, in der sie durch verschiedene Anlagemittel und Rastmittel von oben und unten fixiert wird. Der Halter selbst.rastet z. B. durch Rastarme oder andere Rastmittel in seiner Längsposition in der Haupt-Leiterplatte ein. Gegebenenfalls kann durch zusätzliche Verspannungen ein Verkippen vermieden oder verringert werden.

Somit ist ein einfacher und kostengünstiger Herstellungs- und Montagevorgang möglich. Der Halter selbst kann z. B. als einfaches Druckgrussteil oder Spritzgussteil aus Kunststoff hergestellt werden.

Erfindungsgemäß wird eine sichere und genaue Fixierung in der vertikalen Position der Zusatz-Leiterplatte erreicht, so dass Messfehler weitgehend vermieden werden können.

Die Erfindung wird im Folgenden anhand der beiliegenden Zeichnungen an einer Ausführungsform erläutert.

Es zeigen:
- Fig. 1: eine perspektivische Vorderansicht eines erfindungsgemäßen Schaltungsmoduls;
- Fig. 2: eine perspektivische Rückansicht der Fig. 1;
- Fig. 3: die bestückte, gefräste Leiterplatte vor Anbringen des Halters in leicht perspektivischer Draufsicht;
- Fig. 4: eine leicht perspektivische Draufsicht auf das Schaltungsmodul im Bereich des aufgesetzten Halters;
- Fig. 5: eine perspektivische Vorderansicht des Halters;
- Fig. 6: eine Unteransicht des Halters.

Ein Sensormodul 1 ist als erfindungsgemäßes Schaltungsmodul ausgebildet und weist eine Haupt-Leiterplatte 2 auf, die in bekannter Weise mehrschichtig auf Epoxidharz- oder Kunststoffbasis ausgebildet ist und mehrere, in den Figuren nur angedeutete und ansonsten nicht detaillierter gezeigte Leiterbahnen 3 sowie in bekannter Weise Durchkontaktierungen zwischen den Lagen aufweist. Auf der Haupt-Leiterplatte 2, z. B. nur auf der Oberseite 2a der Haupt-Leiterplatte 2, sind mehrere elektronische Bauelemente 4 als SMD-Bauelemente aufgesetzt und kontaktiert. Insbesondere kann ein Mikrocontroller 4a montiert sein.

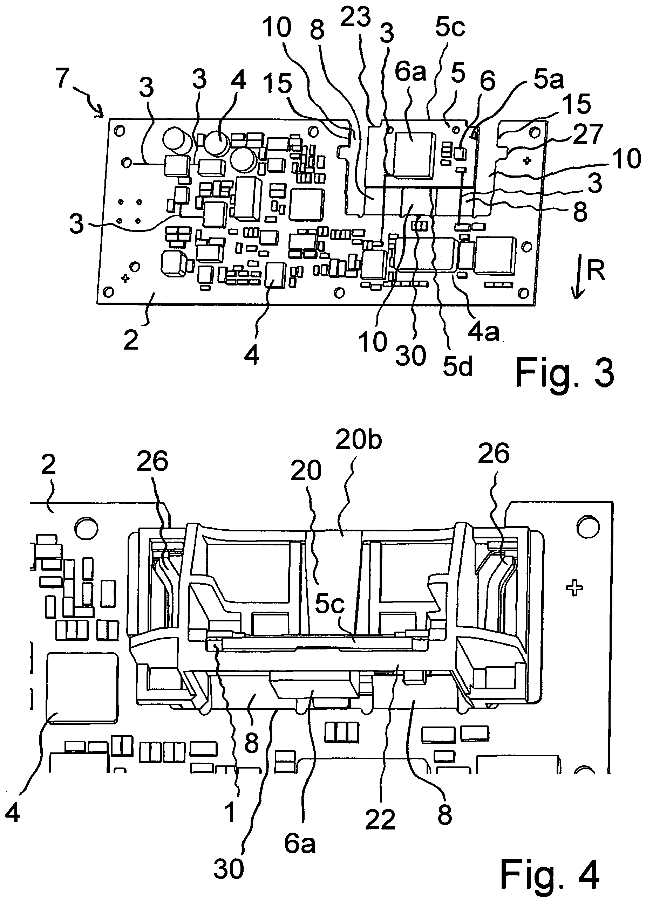

Wie insbesondere aus Fig. 3 erkennbar ist, ist erfindungsgemäß weiterhin eine Zusatz-Leiterplatte 5 vorgesehen, die als Zusatzträger zur Aufnahme weiterer Bauelemente 6, insbesondere eines Sensors 6a bzw. Sensorchips 6a dient. Die Bauelemente 6, 6a sind vorzugsweise auf der Oberseite 5a der Zusatz-Leiterplatte 5 angebracht. Die Zusatz-Leiterplatte 5 ist über zwei flexible, elastische Verbindungsbereiche 8 mit der Haupt-Leiterplatte 2 verbunden, wobei Leiterbahnen 3 durchgängig durch die Haupt-Leiterplatte 2, z. B. an der Unterseite 2b der Haupt-Leiterplatte 2, dann durch die Verbindungsbereiche 8 und anschließend in die Zusatz-Leiterplatte 5 verlaufen und Bauelemente 6, 6a der Zusatz-Leiterplatte 5 mit Bauelementen 4, 4a der Haupt-Leiterplatte 2 kontaktieren, wie in Fig. 3 schematisch und nicht vollständig angedeutet.

Vorteilhafterweise sind die Haupt-Leiterplatte 2 und die Zusatz- Leiterplatte 5 aus einer gemeinsamen Grund-Leiterplatte 7 hergestellt, indem Freiräume 10 zwischen der Haupt-Leiterplatte 2 und der Zusatz-Leiterplatte 5 vollständig ausgefräst werden und die Verbindungsbereiche 8 durch eine unterste flexible Schicht der Grund-Leiterplatte 7 gebildet sind. Somit wird die Grund-Leiterplatte 7 in den Verbindungsbereichen 8 bis auf diese unterste - oder auch oberste - flexible Schicht tiefengefräst, wobei die Leiterbahnen 3 in dieser Schicht nicht beschädigt werden.

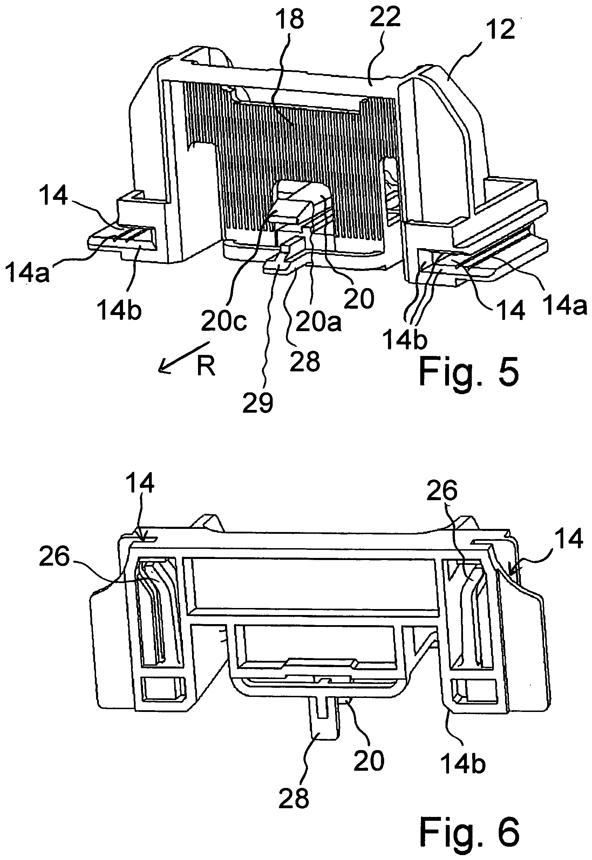

Zur Herstellung des Sensormoduls 1 wird ein Halter 12, der insbesondere als Spritzgussteil aus Kunststoff oder auch mehrteilig bzw. aus mehreren, verschweißten oder verrasteten Teilen ausgebildet sein kann, auf die gefräste, bereits bestückte Grund-Leiterplatte 7 aufgesetzt. Der Halter 12 dient hierbei zur Positionierung der Zusatz-Leiterplatte 5 in einem gewünschten Winkel, insbesondere orthogonal zu der Haupt-Leiterplatte 2. Er kann erfindungsgemäß vorteilhafterweise durch eine einfache translatorische Bewegung ausgesetzt werden. In der gezeigten Ausführungsform erfolgt dies durch einfaches translatorisches Aufschieben in der Schieberichtung R, die in den Ansichten auch die Vorderseite angibt. Der Halter 12 ist in den Fig. 5, 6 ergänzend in Alleinstellung gezeigt und weist zwei seitliche Führungsnuten 14 auf, die sich entlang der Einschieberichtung R erstrecken und Kanten 15 der Haupt-Leiterplatte 2 aufnehmen, die die äu-βere seitliche Begrenzung der Freiräume 10 bilden. Die Ecken zwischen den Kanten 15 und den Außenkanten der Haupt-Leiterplatte 2 sind vorteilhafterweise zur Erleichterung des Einfädelvorgangs abgerundet oder abgeschrägt, d.h. mit Abschrägungen 15a oder Abrundungen 15a ausgebildet. Die Führungsnuten 14 sind vorteilhafterweise in einem unteren, dicker ausgebildeten Bereich des Halters 12 ausgebildet. Hierbei können Einlaufrillen 14a in den Führungsnuten 14 ausgebildet sein, um eine Verteilung des aufgetragenen Flüssiglacks zu ermöglichen. Auch an der Vorderseite des Führungsnuten 14 können entsprechende Abschrägungen oder Abrundungen 14b zur Erleichterung des Einfädelvorgangs ausgebildet sein.

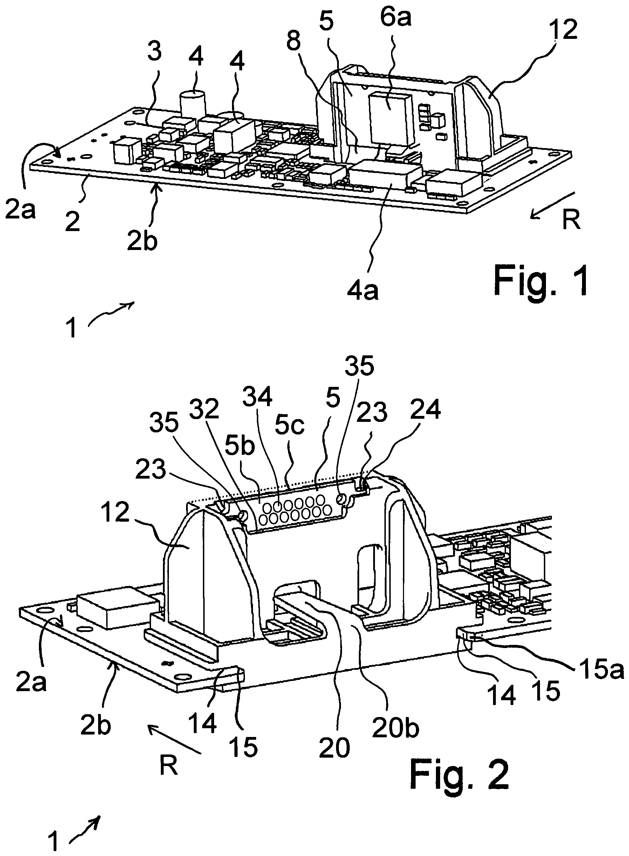

Beim Einfädelvorgang wird somit zunächst der Halter 12 mit seinen Führungsnuten 14 in die Kanten 15 eingeführt und in Einschieberichtung R verschoben. Hierbei gelangt eine in Fig. 2 bis 4 ersichtliche Vorderkante 5c der Zusatz-Leiterplatte 5 gegen eine vertikale Anlagefläche 18 des Halters 12, die zur Vorderseite hin ausgebildet ist und mit einer Riffelung bzw. Rillen 18a versehen ist, die zum einen als Einlaufrillen für den Flüssiglack dienen und weiterhin die Reibung beim Gleitvorgang verringern, bei dem die Vorderkante (Gleitkante) 5c der Zusatz-Leiterplatte 5 an der Anlagefläche 18 entlang rutscht, wobei sich die Zusatz-Leiterplatte 5 während des Gleitvorgangs aufrichtet. Ergänzend können vorteilhafterweise externe Stifte der hier nicht gezeigten Montagevorrichtung eine anfängliche Schrägstellung der Zusatz-Leiterplatte 5 bewirken, so dass der nachfolgende Positioniervorgang der Zusatz-Leiterplatte 5 durch Entlanggleiten an der Anlagefläche 18 sichergestellt ist. Die Anlagefläche 18 ist vorzugsweise mindestens so breit wie die Zusatz-Leiterplatte 5, vorteilhafterweise ist sie zur Ermöglichung von Toleranzen und zur Verhinderung eines Verkantens etwas breiter ausgebildet. Während des Einschiebevorgangs gleitet somit die Zusatz-Leiterplatte 5 an der senkrechten Anlagefläche 18 des Halters 12 hoch und gelangt in eine vertikale Position. Die beiden Verbindungsbereiche 8 (oder alternativ hierzu auch ein gemeinsamer Verbindungsbereich 8) wirken hierbei gelenkig, ohne dass die in ihnen verlaufenden Leiterbahnen 3 beschädigt werden. In der Endposition bilden die Verbindungsbereiche 8 somit eine 90°-Verbindung.

An der Vorderseite des Halters 12 ragt ein mittlerer Schnapphaken 20 offen nach vorne vor, der an seiner Oberseite eine Hinterschneidung bzw. einen Vorsprung 20a zum Hintergreifen einer hinteren Kante 5d der Zusatz-Leiterplatte 5 aufweist. Die Zusatz-Leiterplatte 5 wird somit an einer senkrechten Anlagefläche 18 nach oben geschoben, bis der mittlere Schnapphaken 20 mit seinem Vorsprung 20a (bzw. Hintergreifung) die hintere Kante (Unterkante) 5d der Zusatz-Leiterplatte 15 hintergreift und einschnappt. Der Schnapphaken 20 ist hierzu federnd nachgiebig ausgebildet und z. B. im hinteren Bereich des Halters 12 in einer Anbindung 20b angebunden. Hierdurch weist er eine hinreichend geringe Federsteifigkeit auf, um den Einschiebevorgang nicht zu beeinträchtigen, und ist dennoch hinreichend stabil ausgebildet. Der Vorderbereich des Schnapphakens 20 vor der Hintergreifung 20a ist mit einer Abschrägung 20c versehen, um den Gleitvorgang der Vorderkante 5c beim Einfädelvorgang zu ermöglichen. Vorteilhafterweise wird der Schnapphaken 20 beim Einschieben heruntergedrückt werden, z. B. von Hand, um eine Beschädigung des flexiblen Verbindungsbereichs 8 zu vermeiden. Ergänzend können in der nicht gezeigten Montagevorrichtung zur Sicherheit noch Stifte oder ähnliches vorgesehen sein, die von vorne gegen die Unterkante 5d der Zusatz-Leiterplatte 5 drücken, um in dem Fall, dass der Schnapphaken 20 nicht herunter gedrückt wird, eine Beschädigung des flexiblen Verbindungsbereichs 8 zu verhindern.

Aufgrund der Elastizität bzw. der hinreichenden Steifigkeit des Verbindungsbereiches 8 wird die Zusatz-Leiterplatte 5 beim Einfädelvorgang gegen die Anlagefläche 18 gedrückt. Ergänzend ist ein Gegenhalter 22 z. B. als horizontal verlaufender Steg ausgebildet, der im eingesetzten Zustand die Zusatz-Leiterplatte 5 nach vorne sichert. Somit ist die Zusatz-Leiterplatte nach hinten durch die Anlagefläche 18, nach vorne durch den Gegenhalter 22 und nach unten durch den mittleren Schnapphaken 20 gesichert. Ergänzend sollte vorteilhafterweise auch eine Absicherung nach oben erfolgen, indem die Vorderkante 5c in dem Halter 12 anliegt, wozu an der Vorderkante 5c z. B. seitlich außen Schultern 23 ausgespart sind, die an entsprechende Anschlagflächen 24 des Halters 12 gelangen und z. B. im Übergangsbereich zwischen dem Gegenhalter 22 und der Anlagefläche 18 ausgebildet sein können. Die Anschlagflächen dienen als obere Stütze der Zusatz-Leiterplatte 5 und fangen somit die von dem mittleren Schnapphaken 20 ausgeübte Kraft ab; somit verhindern sie, dass durch die Kraft des mittleren Schnapphakens 20 der flexible Verbindungsbereich 8 dauerhaft belastet und beschädigt wird.

Der Halter 12 weist weiterhin entsprechende Elemente und Mittel zur Befestigung und Fixierung an der Haupt-Leiterplatte 2 auf. Hierbei sind gemäß der gezeigten Ausführungsform zwei seitliche Schnapparme 26 in seitlicher Richtung federnd ausgebildet und gleiten während des Einführvorgangs des Halters 12 zunächst an den Kanten 15 entlang, bis sie bei Erreichen der Endposition in in Fig. 3 gezeigten seitlichen Vertiefungen 27 der Kanten 15 einrasten und somit den Halter 12 nach hinten, d.h. entgegen seiner Einschieberichtung R, fixieren.

Weiterhin ragt ein unterer Steg 28 an dem Halter 12 nach vorne, und gleitet mit einer Schräge 29 unter eine zwischen den Verbindungsbereichen 8 gebildete vordere Kante 30 der Haupt- Leiterplatte 2, so dass der Halter 12 gegen ein Verkippen, insbesondere ein Verkippen um seine Querachse, an der Haupt-Leiterplatte 2 gesichert ist. Somit ist der Halter 12 auch an der Haupt-Leiterplatte 2 vollständig fixiert, nämlich in vertikaler Richtung durch seine Führungsnuten 14, in Längsrichtung durch seine Schnapparme 26, ergänzend gegebenenfalls durch eine vordere Anlage an der Kante 30 und gegen ein Verkippen durch den unteren, elastisch angebundenen, unteren Steg 28. Der Steg 28 kann durch seine Schräge 29 auch in Längsrichtung nach vorne fixieren bzw. eine Verspannung in Längsrichtung bewirken. Indem somit der flexible Verbindungsbereich 8 hinreichend steif ist, kann die Zusatz-Leiterplatte 5 von selbst mit ihrer Unterseite 5b gegen die Anlagefläche 18 des Halters 12 gepresst werden. Somit kann der mittlere Schnapphaken 20 eher eine Zusatz-Sicherungsfunktion einnehmen.

Gemäß Fig. 2 kann in z. B. dem oberen Bereich der Anlagefläche 18 eine Freimachung 32 bzw. Aussparung ausgebildet sein, um im gezeigten eingesetzten Zustand des Halters 12 einen Zugriff zu Kontaktpunkten 34 zu ermöglichen, die auf der Unterseite 5b (bzw. Rückseite) der Zusatz-Leiterplatte 5 ausgebildet sind und einen End-of-Line-Test im eingesetzten Zustand ermöglichen. Hierbei dienen Zentrierungs-Bohrungen 35 zur Zentrierung der End-of-Line-Testvorrichtung, damit die Prüfkontakte der End-of-Line-Testvorrichtung die Kontaktpunkte 34 treffen.

Somit kann der Sensor 6a durch einen einfachen Einschiebevorgang, der selbsttätig durch Einrastung zu einer sicheren Endposition führt, in der in Fig. 1 und 2 gezeigten vertikalen Position positioniert werden. Die Verbindungsbereiche 8 können insbesondere durch Tiefenfräsen ausgebildet werden. Somit werden die Freiräume 10 direkt gefräst und die Verbindungsbereiche 8 durch Tiefenfräsen ausgebildet. Beim Tiefenfräsen wird die Grund-Leiterplatte 7 in bestimmten Bereichen soweit abgefräst, dass nur noch eine Lage übrig ist, die dann ausreichend flexibel ist.

Insbesondere kann zunächst die Grund-Leiterplatte 7 ausgefräst bzw. tiefengefräst und nachfolgend bestückt werden (oder auch in umgekehrter Reihenfolge) und danach der Halter 12 eingeschoben werden. Nach der Montage des Halters 12 kann nachfolgend ein Lack oder Klebemittel aufgebracht werden, um eine zusätzliche Stabilisierung zu erreichen, ergänzend ein Loslösen zu verhindern, und weiterhin auch Schwingungen bzw. Vibrationen der Zusatz-Leiterplatte 5 in dem Halter 12 zu verhindern oder verringern. Der eingebrachte Lack bzw. das Klebemittel kann hierbei z. B. die Oberseite 5a und auch die Unterseite der Zusatz-Leiterplatte 5 sowie den Halter 12, vorteilhafterweise auch zumindest teilweise die Haupt-Leiterplatte 2 benetzen. Die Einlaufrillen 18a der Anlagefläche 18 sowie auch die Einlaufrillen 14a in der Führungsnut 14 ermöglichen hierbei eine gute Benetzung durch den eingebrachten Lack.

Der Sensor 6a ist vorteilhafterweise mikromechanisch als integrierter Schaltkreis ausgebildet und dient insbesondere zur Messung einer oder mehrerer richtungsabhängiger Trägheitsgrößen, d.h. einer Beschleunigung und/oder Drehrate und/oder Drehbeschleunigung; er ist mitsamt der Zusatz-Leiterplatte 5 orthogonal bzw. vertikal zur Haupt-Leiterplatte 2 ausgerichtet. Entsprechend können auch mehrere derartige Sensoren 6a auf der Zusatz-Leiterplatte 5 montiert sein. Weiterhin können vorzugsweise auch auf der Haupt-Leiterplatte 2 entsprechende Sensoren zur Messung einer oder mehrerer richtungsabhängiger Trägheitsgrößen in der Ausrichtung der Haupt-Leiterplatte 2, d.h. senkrecht zum Sensor 6a, vorgesehen sein.

Das gesamte Sensormodul 1 kann insbesondere als vollständige Steuereinrichtung bzw. ECU ausgebildet sein, insbesondere automotive-tauglich, z. B. als Steuergerät einer Fahrzeugregelung, insbesondere einer Fahrdynamikregelung, bei der entsprechende Trägheitsgrößen des Fahrzeuges zu messen und in die Regelung einzubeziehen sind. Das Steuermodul 1 weist vorteilhafterweise ein hier nicht gezeigtes Gehäuse auf, in dem die Haupt-Leiterplatte 2 mitsamt Zusatz-Leiterplatte 5 und Halter 12 aufgenommen ist.

## Patentansprüche

1. Schaltungsmodul, insbesondere zur Aufnahme eines Sensors (6a), wobei das Schaltungsmodul (1) mindestens aufweist:
eine Haupt-Leiterplatte (2), auf oder in der Leiterbahnen (3) ausgebildet sind und auf der mindestens ein Bauelement (4) montiert ist,
ein Zusatz-Träger (5), der als Zusatz-Leiterplatte ausgeführt ist, und auf dem zumindest ein Bauelement (6, 6a) montiert ist, und
ein Halter (12) zur Fixierung des Zusatz-Trägers (5) in einer Winkelstellung an oder auf der Haupt-Leiterplatte (2),
wobei mindestens ein auf dem Zusatzträger (5) montiertes Bauelement (6, 6a) mit der Haupt-Leiterplatte (2) elektrisch kontaktiert ist,
**dadurch gekennzeichnet, dass** in oder auf der Zusatz-Leiterplatte (5) mindestens eine Leiterbahn (3) verläuft,
die Haupt-Leiterplatte (2) und die Zusatz-Leiterplatte (5) über mindestens einen flexiblen Verbindungsbereich (8) miteinander verbunden sind, und
mindestens eine Leiterbahn (3) in oder auf der Zusatz-Leiterplatte (5), durch den Verbindungsbereich (8) und zu der Haupt-Leiterplatte (2) verläuft, wobei die Haupt-Leiterplatte (2) und die Zusatz- Leiterplatte (5) aus einer gemeinsamen Grund-Leiterplatte (7) hergestellt sind und der mindestens eine Verbindungsbereich (8) durch mindestens eine obere oder untere Lage gebildet ist, die die Haupt- Leiterplatte (2) und die Zusatz-Leiterplatte (5) gemeinsam aufweisen, wobei die Zusatz-Leiterplatte (5) in der Haupt-Leiterplatte (2) durch Ausfräsen von Freiräumen (10) und Tiefenfräsen des mindestens einen Verbindungsbereichs (8) von einer Seite her teilweise freigestellt ist, wobei der Halter (12) durch einen translatorischen Montagevorgang an mindestens einer Kante (15) der Haupt-Leiterplatte (2) aufgesetzt ist, wobei
der Halter (12) mittels einer durchgängigen translatorischen Einschiebebewegung in einer Einschieberichtung (R) auf der Haupt- Leiterplatte (2) montiert und fixiert ist und die Zusatz-Leiterplatte (5) durch die Einschiebebewegung in ihre vertikale Position aufgenommen und in dem Halter (12) positioniert und fixiert ist, wobei der Halter (12) eine Anlagefläche (18) zur gleitenden Aufnahme einer Vorderkante (5c) der Zusatz-Leiterplatte (5) bei der Einschiebebewegung aufweist, wobei der Halter (12) zwei seitliche Führungsnuten (14) zur Aufnahme von Kanten (15) der Haupt-Leiterplatte (2) als Führung für die Einschiebebewegung in Einschieberichtung (R) und zur Befestigung des Halters (12) an der Haupt-Leiterplatte (2) in der Einbauposition aufweist, wobei sich die Führungsnuten (14) entlang der Einschieberichtung (R) erstrecken und Kanten (15) der Haupt-Leiterplatte (2) aufnehmen, die die äußere seitliche Begrenzung der Freiräume (10) bilden.

2. Schaltungsmodul nach Anspruch 1, **dadurch gekennzeichnet, dass** die Winkelstellung eine orthogonale Position des Zusatz-Trägers (5) an oder auf der Haupt-Leiterplatte (2) ist.

3. Schaltungsmodul nach Anspruch 1 oder 2, **dadurch gekennzeichnet, dass** der mindestens eine Verbindungsbereich (8) als flexible, elastische Schicht ausgebildet ist, die sich von der Oberseite (2a) oder der Unterseite (2b) der Haupt-Leiterplatte (2) bis auf die Oberseite (5a) oder Unterseite (5b) der Zusatz-Leiterplatte (5) erstreckt und einen gekrümmten Verlauf aufweist.

4. Schaltungsmodul nach einem der vorherigen Ansprüche, **dadurch gekennzeichnet, dass** sämtliche zwischen der Zusatz-Leiterplatte (5) und der Haupt- Leiterplatte (2) verlaufende elektrischen Verbindungen als durch den mindestens einen Verbindungsbereich (8) verlaufende Leiterbahnen (3) ausgebildet sind.

5. Schaltungsmodul nach einem der vorherigen Ansprüche, **dadurch gekennzeichnet, dass** der Halter (12) Fixierungsmittel (20, 20a, 24) zur vertikalen Fixierung der Vorderkante (5c) und/oder der Unterkante (5d) der Zusatz-Leiterplatte (5) in der Einbauposition aufweist.

6. Schaltungsmodul nach Anspruch 5 **dadurch gekennzeichnet, dass** als Fixierungselement zur Fixierung der Unterkante (5d) der Zusatz-Leiterplatte (5) ein in Einschieberichtung (R) verlaufender elastischer Schnapphaken (20) vorgesehen ist, der eine Abschrägung (20c) zur gleitfähigen Aufnahme der Zusatz-Leiterplatte (5) während der Einführungsbewegung aufweist.

7. Schaltungsmodul nach einem der vorherigen Ansprüche, **dadurch gekennzeichnet, dass** der Halter (12) eine Klemmeinrichtung, z. B. seitliche, elastische Schnapparme (26), zur Positionierung und Fixierung in Einschieberichtung (R) des Halters (12) an der Haupt-Leiterplatte (2) aufweist.

8. Schaltungsmodul nach einem der vorherigen Ansprüche, **dadurch gekennzeichnet, dass** zwischen der Haupt-Leiterplatte (2) und der Zusatz-Leiterplatte (5) mindestens zwei elastische Verbindungsbereiche (8) ausgebildet sind, zwischen denen ein Freiraum (10) ausgebildet ist, wobei ein an der Vorderseite des Halters (12) vorgesehnes Klemmmittel, z. B. ein elastischer Steg (28), bei der Einschiebebewegung gegen eine den Freiraum begrenzende Kante (30) der Haupt-Leiterplatte (2) gelangt und mit einer Klemmwirkung an dieser anliegt.

9. Schaltungsmodul nach einem der vorherigen Ansprüche, **dadurch gekennzeichnet, dass** auf der Zusatz-Leiterplatte (5) ein Sensor (6a) zur Messung einer oder mehrerer richtungsabhängiger Trägheitsgrößen, insbesondere einer translatorischen Beschleunigung und/oder Drehrate und/oder Drehbeschleunigung, angebracht ist und über die Leiterbahnen (3) Sensorsignale oder aus den Sensorsignalen gebildete weitere Signale zu der Haupt-Leiterplatte (2) übertragen werden.

10. Schaltungsmodul nach Anspruch 9, **dadurch gekennzeichnet, dass** es eine Steuereinrichtung für ein Fahrzeugsystem, insbesondere ein Fahrdynamikregelsystem ist.

## Claims

1. Circuit module, in particular for accommodating a sensor (6a), wherein the circuit module (1) has at least:
a main circuit board (2) on which or in which conductor tracks (3) are formed and on which at least component (4) is mounted,
an additional carrier (5) which is embodied as an additional circuit board and on which at least one component (6, 6a) is mounted, and a holder (12) for securing the additional carrier (5) at an angular position at or on the main circuit board (2),
wherein at least one component (6, 6a) which is mounted on the additional carrier (5) is placed in electrical contact with the main circuit board (2),
**characterized in that** at least one conductor track (3) runs in or on the additional circuit board (5), the main circuit board (2) and the additional circuit board (5) are connected to one another via at least one flexible connecting region (8) and at least one conductor track (3) runs in or on the additional circuit board (5), through the connecting region (8) and to the main circuit board (2), wherein the main circuit board (2) and the additional circuit board (5) are manufactured from a common basic circuit board (7), and the at least one connecting region (8) is formed by at least one upper or lower layer which the main circuit board (2) and the additional circuit board (5) have in common, wherein the additional circuit board (5) is partially exposed from one side in the main circuit board (2) by milling out free spaces (10) and deep milling the at least one connecting region (8), wherein the holder (12) is fitted onto at least one edge (15) of the main circuit board (2) by means of a translatory mounting process, wherein the holder (12) is mounted on the main circuit board (2) by means of a continuous translatory pushing-in movement in a pushing-in direction (R) and is secured, and the additional circuit board (5) is raised into its vertical position by the pushing-in movement and positioned and secured in the holder (12), wherein the holder (12) has a bearing face (18) for receiving a front edge (5c) of the additional circuit board (5) in a sliding fashion during the pushing-in movement, wherein the holder (12) has two lateral guide grooves (14) for receiving edges (15) of the main circuit board (2) as a guide for the pushing-in movement in the pushing-in direction (R) and for fastening the holder (12) to the main circuit board (2) in the installation position, and wherein the guide grooves (14) extend along the pushing-in direction (R) and receive edges (15) of the main circuit board (2) which form the outer lateral boundary of the free spaces (10).

2. Circuit module according to Claim 1, **characterized in that** the angular position is an orthogonal position of the additional carrier (5) at or on the main circuit board (2).

3. Circuit module according to Claim 1 or 2, **characterized in that** the at least one connection region (8) is embodied as a flexible elastic layer which extends from the upper side (2a) or the underside (2b) of the main circuit board (2) as far as the upper side (5a) or underside (5b) of the additional circuit board (5) and has a curved profile.

4. Circuit module according to one of the preceding claims, **characterized in that** all the electrical connections which run between the additional circuit board (5) and the main circuit board (2) are embodied as conductor tracks (3) running through the at least one connecting region (8).

5. Circuit module according to one of the preceding claims, **characterized in that** the holder (12) has securing means (20, 20a, 24) for vertically securing the front edge (5c) and/or the lower edge (5d) of the additional circuit board (5) in the installation position.

6. Circuit module according to Claim 5, **characterized in that** an elastic snap-action hook (20) which runs in the pushing-in direction (R) is provided as a securing element for securing the lower edge (5d) of the additional circuit board (5), which hook (20) has a chamfer (20c) for receiving the additional circuit board (5) in a slideable fashion during the insertion movement.

7. Circuit module according to one of the preceding claims, **characterized in that** the holder (12) has a clamping device, e.g. lateral, elastic snap-action arms (26) to be positioned and secured to the main circuit board (2) in the pushing-in direction (R) of the holder (12).

8. Circuit module according to one of the preceding claims, **characterized in that** at least two elastic connecting regions (8) are formed between the main circuit board (2) and the additional circuit board (5), between which connecting regions (8) a free space (10) is formed, wherein during the pushing-in movement a clamping means, e.g. an elastic web (28), which is provided on the front side of the holder (12) moves towards an edge (30), bounding the free space, of the main circuit board (2) and bears with a clamping effect on said edge (30).

9. Circuit module according to one of the preceding claims, **characterized in that** a sensor (6a) for measuring one or more direction-dependent inertia variables, in particular translatory acceleration and/or rotational rate and/or rotational acceleration is mounted on the additional circuit board (5), and sensor signals or further signals which are formed from the sensor signals are transmitted to the main circuit board (2) via the conductor tracks (3).

10. Circuit module according to Claim 9,
**characterized in that** it is a control device for a vehicle system, in particular a vehicle movement dynamics control system.

## Revendications

1. Module de circuit, notamment destiné à accueillir un capteur (6a), le module de circuit (1) possédant au moins :
une carte à circuit imprimé principale (2), sur ou dans laquelle sont formées des pistes conductrices (3) et sur laquelle est monté au moins un composant (4),
un élément porteur supplémentaire (5), qui est réalisé sous la forme d'une carte à circuit imprimé supplémentaire et sur lequel est monté au moins un composant (6, 6a), et
un élément de maintien (12) servant au calage de l'élément porteur supplémentaire (5) dans une position angulaire contre ou sur la carte à circuit imprimé principale (2),
au moins un composant (6, 6a) monté sur l'élément porteur supplémentaire (5) étant mis en contact électrique avec la carte à circuit imprimé principale (2),
**caractérisé en ce que**
au moins une piste conductrice (3) est tracée dans ou sur la carte à circuit imprimé supplémentaire (5),
la carte à circuit imprimé principale (2) et la carte à circuit imprimé supplémentaire (5) sont reliées l'une à l'autre par le biais d'au moins une zone de liaison flexible (8) et
au moins une poste conductrice (3) dans ou sur la carte à circuit imprimé supplémentaire (5) suit un tracé à travers la zone de liaison flexible (8) et vers la carte à circuit imprimé principale (2), la carte à circuit imprimé principale (2) et la carte à circuit imprimé supplémentaire (5) étant fabriquées à partir d'une carte à circuit imprimé de base (7) commune et l'au moins une zone de liaison (8) étant formée par au moins une couche supérieure ou inférieure que présentent ensemble la carte à circuit imprimé principale (2) et la carte à circuit imprimé supplémentaire (5), la carte à circuit imprimé supplémentaire (5) étant partiellement détourée dans la carte à circuit imprimé principale (2) par fraisage d'espaces libres (10) et fraisage en profondeur de l'au moins une zone de liaison (8) depuis un côté, l'élément de maintien (12) étant posé au niveau d'au moins un bord (15) de la carte à circuit imprimé principale (2) par une opération de montage translatoire, l'élément de maintien (12) étant monté et calé sur la carte à circuit imprimé principale (2) au moyen d'un mouvement d'insertion translatoire continu dans une direction d'insertion (R) et la carte à circuit imprimé supplémentaire (5) étant accueillie dans sa position verticale par le mouvement d'insertion puis positionnée et calée dans l'élément de maintien (12), l'élément de maintien (12) possédant une surface d'appui (18) destinée à accueillir avec glissement un bord avant (5c) de la carte à circuit imprimé supplémentaire (5) lors du mouvement d'insertion, l'élément de maintien (12) possédant deux rainures de guidage (14) latérales destinées à accueillir des bords (15) de la carte à circuit imprimé principale (2) en tant que guidage pour le mouvement d'insertion dans la direction d'insertion (R) et servant à la fixation de l'élément de maintien (12) à la carte à circuit imprimé principale (2) dans la position installée, les rainures de guidage (14) s'étendant le long de la direction d'insertion (R) et accueillant les bords (15) de la carte à circuit imprimé principale (2) qui forment la délimitation latérale externe des espaces libres (10).

2. Module de circuit selon la revendication 1, **caractérisé en ce que** la position angulaire est une position orthogonale de l'élément porteur supplémentaire (5) contre ou sur la carte à circuit imprimé principale (2).

3. Module de circuit selon la revendication 1 ou 2, **caractérisé en ce que** l'au moins une zone de liaison (8) est réalisée sous la forme d'une couche élastique flexible qui s'étend depuis le côté supérieur (2a) ou le côté inférieur (2b) de la carte à circuit imprimé principale (2) jusqu'au côté supérieur (5a) ou au côté inférieur (5b) de la carte à circuit imprimé supplémentaire (5) et possède un tracé curviligne.

4. Module de circuit selon l'une des revendications précédentes, **caractérisé en ce que** toutes les liaisons électriques suivant un tracé entre la carte à circuit imprimé supplémentaire (5) et la carte à circuit imprimé principale (2) sont réalisées sous la forme de pistes conductrices (3) qui suivent un tracé à travers l'au moins une zone de liaison (8).

5. Module de circuit selon l'une des revendications précédentes, **caractérisé en ce que** l'élément de maintien (12) possède des moyens de calage (20, 20a, 24) destinés au calage vertical du bord avant (5c) et/ou du bord inférieur (5d) de la carte à circuit imprimé supplémentaire (5) dans la position installée.

6. Module de circuit selon la revendication 5, **caractérisé en ce que** l'élément de calage destiné au calage du bord inférieur (5d) de la carte à circuit imprimé supplémentaire (5) est un crochet d'encliquetage (20) élastique qui suit un tracé dans la direction d'insertion (R), lequel possède un chanfreinage (20c) destiné à accueillir de manière glissante la carte à circuit imprimé supplémentaire (5) pendant le mouvement d'insertion.

7. Module de circuit selon l'une des revendications précédentes, **caractérisé en ce que** l'élément de maintien (12) possède un dispositif de serrage, par exemple des bras d'encliquetage (26) élastiques latéraux, servant au positionnement et au calage dans la direction d'insertion (R) de l'élément de maintien (12) contre la carte à circuit imprimé principale (2).

8. Module de circuit selon l'une des revendications précédentes, **caractérisé en ce qu'**entre la carte à circuit imprimé principale (2) et la carte à circuit imprimé supplémentaire (5) sont formées au moins deux zones de liaison (8) élastiques entre lesquelles est formé un espace libre (10), un moyen de serrage présent au niveau du côté avant de l'élément de maintien (12), par exemple une nervure (28) élastique, se retrouvant, lors du mouvement d'insertion, contre un bord (30) de la carte à circuit imprimé principale (2) qui délimite l'espace libre et reposant contre celui-ci avec un effet de serrage.

9. Module de circuit selon l'une des revendications précédentes, **caractérisé en ce qu'**un capteur (6a) destiné à mesurer une ou plusieurs grandeurs d'inertie dépendantes de la direction, notamment une accélération translatoire et/ou une vitesse de rotation et/ou une accélération en rotation, est monté sur la carte à circuit imprimé supplémentaire (5) et des signaux de capteur ou des signaux supplémentaires formés à partir des signaux de capteur sont transmis vers la carte à circuit imprimé principale (2) par le biais des pistes conductrices (3).

10. Module de circuit selon la revendication 9, **caractérisé en ce qu'**il est un dispositif de commande pour un système de véhicule, notamment un système de régulation de la dynamique de conduite.
